# EUROPEAN PATENT APPLICATION

(11) **EP 4 657 868 A1**
(43) Date of publication of application: **03.12.2025**
(21) Application number: 24764199.6
(22) Date of filing: 28.02.2024
(51) Int. Cl.: H04N 23/52, H04N 23/54, H05K 1/02

(54) **CAMERA MODULE AND ELECTRONIC DEVICE COMPRISING SAME**

(30) Priority: 02.03.2023 KR 20230028013; 03.04.2023 KR 20230043506
(71) Applicant: Samsung Electronics Co., Ltd., Suwon-si, Gyeonggi-do 16677 (KR)
(72) Inventor: PARK, Jungmin, Suwon-si, Gyeonggi-do 16677 (KR); HAN, Janghoon, Suwon-si, Gyeonggi-do 16677 (KR)
(74) Representative: HGF
(86) International application number: PCT/KR2024/002581
(87) International publication number: WO 2024/181800

(57) **Abstract**

A camera module and an electronic device comprising same are disclosed. The electronic device according to various embodiments of the present invention comprises a camera module and is constituted to communicate in at least one RF frequency band, wherein the camera module may comprise: a first substrate which includes a sensor hole formed at a first surface of the first substrate to pass through at least a part of the first substrate; an image sensor at least a part of which is positioned in the sensor hole and which is electrically connected to the first substrate; and a second substrate which is arranged at the opposite surface to the first surface of the first substrate to partially overlap the sensor hole and includes at least one conductive pattern.

## Description

### [Technical Field]

Various embodiments disclosed in this document relate to a camera of an electronic device, and more particularly, to RF shielding of a camera of an electronic device.

### [Background Art]

An electronic device may include at least one camera for performing various functions such as capturing still images and moving images, video calling, or augmented reality (AR). The camera may convert an optical image formed by an optical system into electronic image information through a sensor. The camera may be mounted on the electronic device in the form of a camera module electrically connected to a circuit board of the electronic device. The camera may include various optical components in order to correct aberrations of the optical system and improve an image quality. Therefore, the size of the camera module may increase to improve an image quality of the camera module.

Electronic devices may communicate using electromagnetic waves in various frequency bands. Electronic devices may include RF circuitry including components such as amplifiers, waveguides, and antennas for communication. The RF circuitry may generate EMI to other components of the electronic device.

### [Disclosure of Invention]

### [Technical Solution]

Electromagnetic interference (EMI) emitted during various communication processes of electronic devices may enter a camera through various paths to cause various failures such as increased image noise levels or malfunctions of a shutter and/or AF. In the case of shielding the camera module for this purpose, the size of the camera module may increase due to the shielding.

Various embodiments disclosed in this document may provide a camera module including a shielding member that suppresses an increase in the size of the camera module and protects it from electromagnetic interference, and an electronic device including the same.

According to various embodiments of the disclosure, an electronic device including a camera module and configured to communicate in at least one RF frequency band, wherein the camera module may include a first substrate including a sensor hole formed on a first surface of the first substrate so as to at least partially penetrate the first substrate; an image sensor positioned at least partially within the sensor hole and electrically connected to the first substrate; and a second substrate disposed to partially overlap the sensor hole at a surface opposite to the first surface of the first substrate and including at least one conductive pattern.

According to various embodiments of the disclosure, a camera module included in an electronic device configured to communicate in at least one RF frequency band may include a first substrate including a sensor hole formed on a first surface of the first substrate so as to at least partially penetrate the first substrate; an image sensor positioned at least partially within the sensor hole and electrically connected to the first substrate; and a second substrate disposed to partially overlap the sensor hole at a surface opposite to the first surface of the first substrate and including at least one conductive pattern.

According to various embodiments disclosed in this document, a camera module and an electronic device including the same can be provided that effectively blocks EMI through a plurality of conductive patterns formed on a shielding circuit board and a shielding control circuit connected thereto.

### [Brief Description of Drawings]

In connection with the description of the drawings, the same or similar reference numerals may be used for the same or similar components.
FIG. 1 is a block diagram illustrating an internal constitution of an electronic device according to an embodiment of the disclosure.
FIG. 2 is a perspective view illustrating a front surface of an electronic device according to an embodiment.
FIG. 3 is a perspective view illustrating a rear surface of the electronic device of FIG. 2 according to an embodiment.
FIG. 4 is an exploded view illustrating the electronic device of FIG. 2 according to an embodiment.
FIG. 5A is a cross-sectional view illustrating a camera module according to various embodiments of the disclosure.
FIG. 5B is an exploded perspective view illustrating a camera module according to various embodiments of the disclosure.
FIG. 6A is a plan view illustrating a second substrate and shielding control circuit of a camera module according to various embodiments.
FIG. 6B is a plan view illustrating a second substrate of a camera module according to various embodiments.
FIG. 7A is a schematic diagram illustrating a camera module according to a comparative example and an embodiment of the disclosure.
FIG. 7B is a graph illustrating a shielding performance for a frequency band of a camera module according to a comparative example and an embodiment of the disclosure.

### [Mode for the Invention]

Hereinafter, preferred embodiments of the disclosure will be described in detail with reference to the accompanying drawings. In these drawings, for example, the size and shape of elements may be exaggerated for convenience and clarity of description, and variations in the illustrated shapes may be expected in actual implementation. Accordingly, the embodiments of the disclosure should not be construed as being limited to specific shapes of areas illustrated in this specification.

Reference numerals of elements in the drawings refer to the same elements throughout the drawings. Further, as used in this specification, the term "and/or" includes any and all combinations of one or more of the listed items.

Embodiments of the disclosure are provided to more completely describe the disclosure to those skilled in the art, and the following embodiments may be modified in various other forms, and the scope of the disclosure is not limited to the following embodiments. Rather, these embodiments are provided to make the disclosure more faithful and complete, and to fully convey the spirit of the disclosure to those skilled in the art.

Terms used in this specification are used for describing embodiments and are not intended to limit the scope of the disclosure. Further, even if the singular is described in this specification, the singular may include the plural form unless the context clearly dictates otherwise. Further, terms "comprise" and/or "comprising" used in this specification specify the presence of stated shapes, numbers, steps, operations, members, elements and/or groups thereof, but do not exclude the presence or addition of other shapes, numbers, operations, members, elements and/or groups.

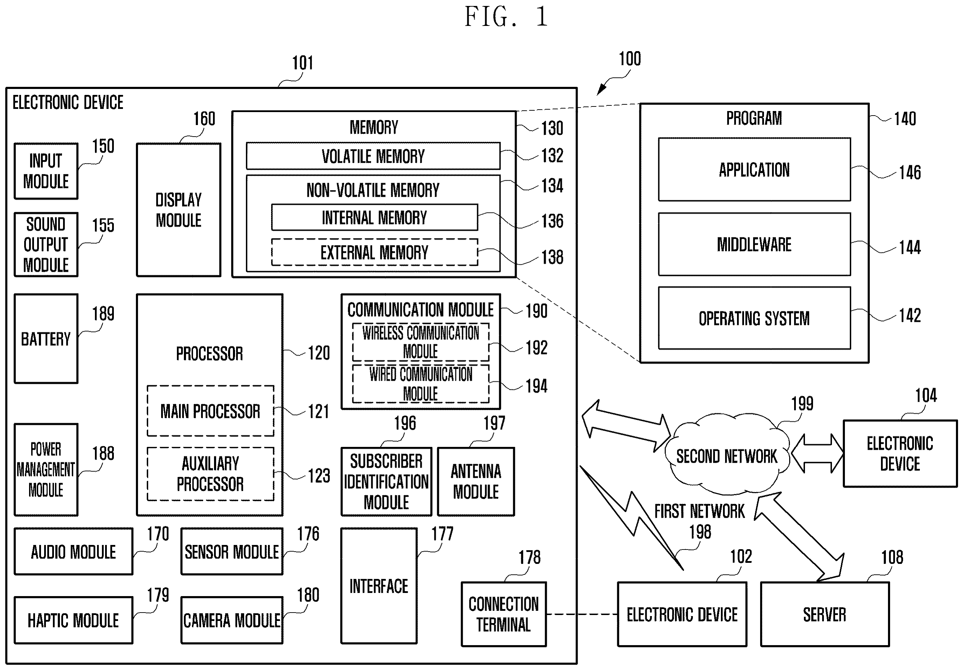

FIG. 1 is a block diagram illustrating an example electronic device 101 in a network environment 100 according to various embodiments. Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In various embodiments, at least one of the components (e.g., the connecting terminal 178) may be omitted from the electronic device 101, or one or more other components may be added in the electronic device 101. In various embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In an embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or loT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, a home appliance, or the like. According to an embodiment of the disclosure, the electronic devices are not limited to those described above.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), the element may be coupled with the other element directly (e.g., wiredly), wirelessly, or via a third element.

As used in connection with various embodiments of the disclosure, the term "module" may include a unit implemented in hardware, software, or firmware, or any combination thereof, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the "non-transitory" storage medium is a tangible device, and may not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

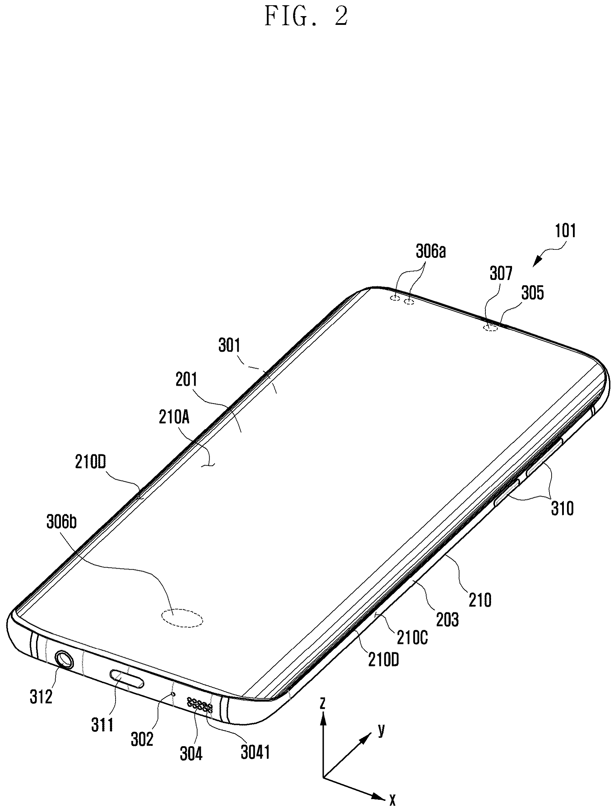

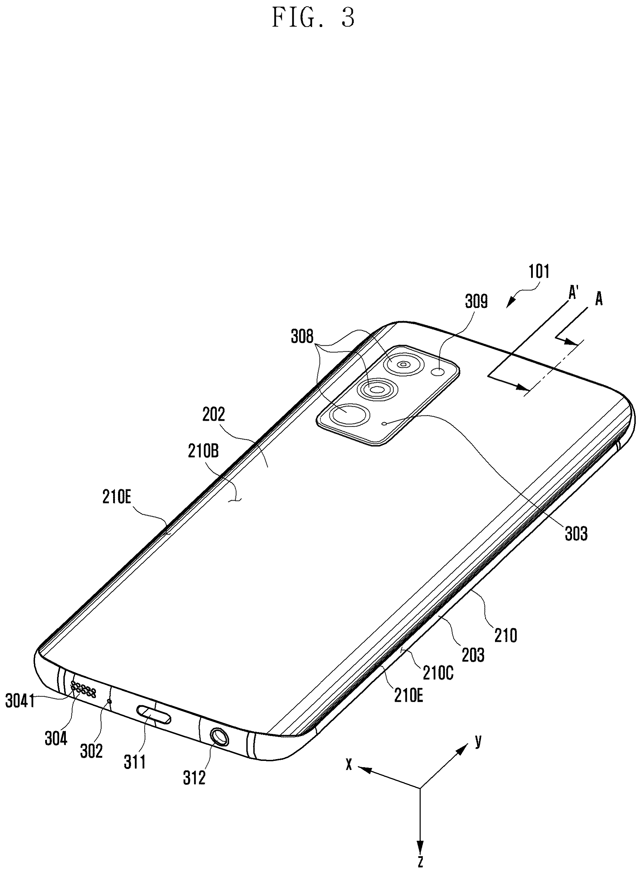

FIG. 2 is a perspective view illustrating a front surface of an electronic device 200 according to an embodiment. FIG. 3 is a perspective view illustrating a rear surface of the electronic device 200 of FIG. 2 according to an embodiment.

With reference to FIGS. 2 and 3, in an embodiment, the electronic device 200 (e.g., the electronic device 101 of FIG. 1) may include a housing 210 including a first surface (or front surface) 210A, a second surface (or rear surface) 210B, and a side surface 210C that encloses a space between the first surface 210A and the second surface 210B. In some embodiments, the housing 210 may refer to a structure that forms at least a portion of the first surface 210A, the second surface 210B, and the side surface 210C. The first surface 210A may be formed by a front window (or first plate) 201 (e.g., a polymer plate or a glass plate including various coating layers) that is at least partially substantially transparent. The second surface 210B may be formed by a substantially opaque rear plate (or second plate) 202. The rear plate 202 may be formed by, for example, coated or colored glass, ceramic, a polymer, a metal (e.g., aluminum, stainless steel (STS), or magnesium), or a combination of at least two of the foregoing materials. The side surface 210C may be formed by a side bezel structure (or "lateral member") 203 coupled with the front window 201 and the rear plate 202, and the side bezel structure 203 may include a metal and/or a polymer. In some embodiments, the rear plate 202 and the side bezel structure 203 may be formed integrally and include the same material (e.g., a metal material such as aluminum).

In an embodiment, the front window 201 may include two first areas 210D bent from the first surface 210A toward the rear plate 202 to be extended seamlessly. The first areas 210D may be formed adjacent to respective long edges of the front window 201. The rear plate 202 may include two second areas 210E bent from the second surface 210B toward the front window 201 to be extended seamlessly. The second areas 210E may be formed adjacent to respective long edges of the rear plate 202. The side surface 210C may have a first thickness (or width) (e.g., height in the z-axis direction) at a side where the first areas 210D and the second areas 210E are not positioned, and have a second thickness smaller than the first thickness at a side where the first areas 210D and the second areas 210E are positioned. In some embodiments, the front window 201 may be implemented including one of the first areas 210D, or may be implemented without the curved first areas 210D. In some embodiments, the rear plate 202 may be implemented including one of the second areas 210E, or may be implemented without the curved second areas 210E.

According to an embodiment, the electronic device 200 may include at least one of a display 301, a first audio module 302, a second audio module 303, a third audio module 304, a fourth audio module 305, a sensor module 306a, a first camera module 307, a plurality of second camera modules 308, a light emitting module 309, an input module 310, a first connection terminal module 311, or a second connection terminal module 312. In some embodiments, the electronic device 200 may omit at least one of the above components or may additionally include other components.

A display area (e.g., screen display area or active area) of the display 301 may be visually exposed, for example, through the front window 201. In an embodiment, the electronic device 200 may be implemented to maximize the display area visible through the front window 201 (e.g., large screen or full screen). For example, the display 301 may be implemented to have an outline having substantially the same shape as an outline shape of the front window 201. For another example, a gap between the outline of the display 301 and the outline of the front window 201 may be formed to be substantially the same. In an embodiment, the display 301 may include a touch sensing circuit. In some embodiments, the display 301 may include a pressure sensor that may measure the intensity (pressure) of a touch. In some embodiments, the display 301 may be coupled with or positioned adjacent to a digitizer (e.g., electromagnetic induction panel) that detects a magnetic field-type electronic pen (e.g., stylus pen).

The first audio module 302 may include, for example, a first microphone positioned inside the electronic device 200, and a first microphone hole formed at the side surface 210C corresponding to the first microphone. The second audio module 303 may include, for example, a second microphone (or second microphone module) positioned inside the electronic device 200, and a second microphone hole formed at the second surface 210B corresponding to the second microphone. The position or number of audio modules with respect to the microphones is not limited to the illustrated example and may vary. In some embodiments, the electronic device 200 may include a plurality of microphones used for detecting a direction of sound.

The third audio module 304 may include, for example, a first speaker (or first speaker module) positioned inside the electronic device 200, and a first speaker hole formed at the side surface 210C corresponding to the first speaker. The fourth audio module 305 may include, for example, a second speaker (or second speaker module) positioned inside the electronic device 200, and a second speaker hole formed at the first surface 210A corresponding to the second speaker. In an embodiment, the first speaker may include an external speaker. In an embodiment, the second speaker may include a call receiver, and the second speaker hole may be referred to as a receiver hole. The position or number of the third audio module 304 or the fourth audio module 305 is not limited to the illustrated example and may vary. In some embodiments, the microphone hole and the speaker hole may be implemented into a single hole. In some embodiments, the third audio module 304 or the fourth audio module 305 may include a piezoelectric speaker without a speaker hole.

The sensor module 306a may generate, for example, an electrical signal or data value corresponding to an internal operating state of the electronic device 200 or an external environmental state. In an embodiment, the sensor module 306a may include an optical sensor positioned inside the electronic device 200 corresponding to the first surface 210A. The optical sensor may include, for example, a proximity sensor or an illuminance sensor. The optical sensor may be aligned with an opening formed in the display 301. External light may enter the optical sensor through the opening of the display 301 and the front window 201. In some embodiments, the optical sensor may be disposed at the bottom of the display 301 and perform related functions without the position of the optical sensor being visually distinguished (or exposed). For example, the optical sensor may be positioned at the rear surface of the display 301, or below or beneath the display 301. In some embodiments, the optical sensor may be aligned and positioned in a recess formed at the rear surface of the display 301. The optical sensor may be disposed to overlap at least a portion of the screen to perform a sensing function without being exposed to the outside. In this case, a partial area of the display 301 that overlaps at least a portion of the optical sensor may have a different pixel structure and/or wiring structure compared to other areas. For example, a partial area of the display 301 that overlaps at least a portion of the optical sensor may have a different pixel density compared to other areas. In some embodiments, in a partial area of the display 301 that overlaps at least a portion of the optical sensor, a plurality of pixels may not be disposed. In some embodiments, the electronic device 200 may include a biometric sensor (e.g., fingerprint sensor 306b) positioned under the display 301. The biometric sensor may be implemented in an optical or ultrasonic manner, and a position or number thereof may vary. The electronic device 200 may further include at least one of various sensor modules, for example, a gesture sensor, a gyro sensor, an atmospheric pressure sensor, a magnetic sensor, an acceleration sensor, a grip sensor, a color sensor, an infrared (IR) sensor, a temperature sensor, or a humidity sensor.

The first camera module 307 (e.g., front camera module) may be positioned, for example, inside the electronic device 200 corresponding to the first surface 210A. A plurality of second camera modules 308 (e.g., rear camera modules) may be positioned, for example, inside the electronic device 200 corresponding to the second surface 210B. The first camera module 307 and/or the plurality of second camera modules 308 may include one or more lenses, an image sensor, and/or an image signal processor. The position or number of the first camera module or the second camera modules is not limited to the illustrated example and may vary.

According to an embodiment, the display 301 may include an opening aligned with the first camera module 307. External light may reach the first camera module 307 through the opening of the display 301 and the front window 201. In some embodiments, the opening of the display 301 may be formed in a notch shape according to the position of the first camera module 307. In some embodiments, the first camera module 307 may be disposed at the bottom of the display 301 and perform related functions (e.g., image capturing) without the position of the first camera module 307 being visually distinguishable (or exposed). For example, the first camera module 307 may be positioned at the rear surface of the display 301, or below or beneath the display 301, and include a hidden display rear camera (e.g., under display camera (UDC)). In some embodiments, the first camera module 307 may be aligned and positioned in a recess formed at the rear surface of the display 301. The first camera module 307 may be disposed to overlap at least a portion of the screen to acquire an image of an external subject without being visually exposed to the outside. In this case, a partial area of the display 301 at least partially overlapped with the first camera module 307 may include a different pixel structure and/or wiring structure compared to other areas. For example, a partial area of the display 301 at least partially overlapped with the first camera module 307 may have a different pixel density compared to other areas. A pixel structure and/or a wiring structure formed in a partial area of the display 301 at least partially overlapped with the first camera module 307 may reduce light loss between the outside and the first camera module 307. In some embodiments, pixels may not be disposed in a partial area of the display 301 that overlaps at least partially with the first camera module 307. In some embodiments, the electronic device 200 may further include a light emitting module (e.g., light source) positioned inside the electronic device 200 corresponding to the first surface 210A. The light emitting module may provide status information of the electronic device 200 in the form of light, for example. In some embodiments, the light emitting module may provide a light source linked to the operation of the first camera module 307. The light emitting module may include, for example, a light emitting diode (LED), an IR LED, or a xenon lamp.

According to an embodiment, the plurality of second camera modules 308 may have different properties (e.g., angles of view) or functions, and include, for example, dual cameras or triple cameras. The plurality of second camera modules 308 may include a plurality of camera modules including lenses having different angles of view, and the electronic device 200 may control to change the angle of view of the camera modules performed in the electronic device 200 based on a user's selection. The plurality of second camera modules 308 may include at least one of a wide angle camera, a telephoto camera, a color camera, a monochrome camera, or an infrared (IR) camera (e.g., time of flight (TOF) camera, structured light camera). In some embodiments, the IR camera may be operated as at least a part of the sensor module. The light emitting module 309 (e.g., flash) may include a light source for the plurality of second camera modules 308. The light emitting module 309 may include, for example, an LED or a xenon lamp.

The input module 310 may include, for example, one or more key input devices. The one or more key input devices may be positioned, for example, in an opening formed at the side surface 210C. In some embodiments, the electronic device 200 may not include some or all of the key input devices, and the key input devices that are not included may be implemented into soft keys using the display 301. The position or number of the input modules 310 may vary, and in some embodiments, the input module 310 may include at least one sensor module.

The first connection terminal module (e.g., first connector module or first interface terminal module) 311 may include, for example, a first connector (or first interface terminal) located inside the electronic device 200, and a first connector hole formed at the side surface 210C corresponding to the first connector. The second connection terminal module (e.g., second connector module or second interface terminal module) 312 may include, for example, a second connector (or second interface terminal) positioned inside the electronic device 200, and a second connector hole formed at the side surface 210C corresponding to the second connector. The electronic device 200 may transmit and/or receive power and/or data to and from an external electronic device electrically connected to the first connector or the second connector. In an embodiment, the first connector may include a universal serial bus (USB) connector or a high definition multimedia interface (HDMI) connector. In an embodiment, the second connector may include an audio connector (e.g., headphone connector or earset connector). The position or number of the connection terminal modules are not limited to the illustrated examples and may vary.

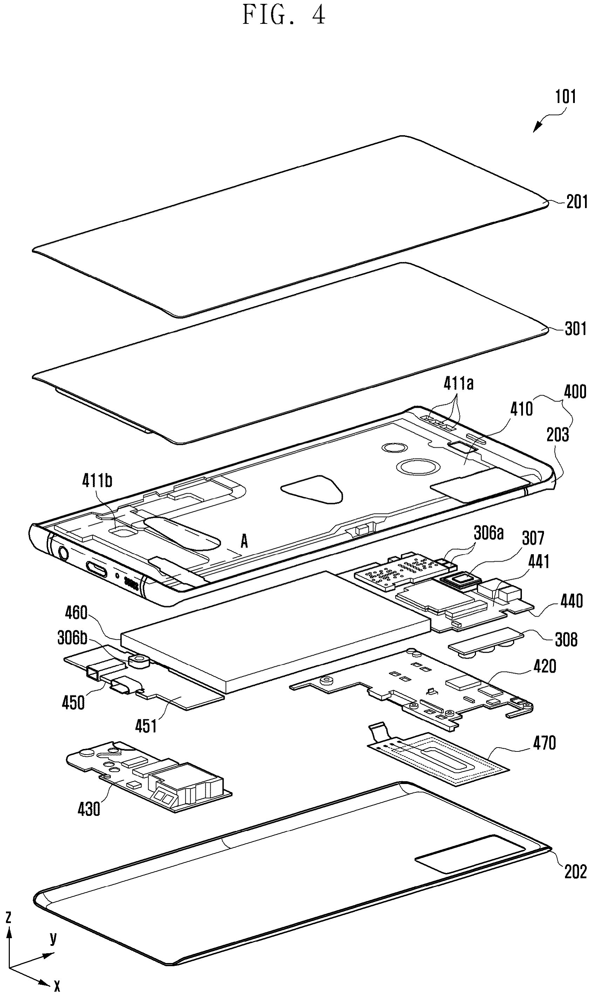

FIG. 4 is an exploded view illustrating the electronic device 200 of FIG. 2 according to an embodiment.

With reference to FIG. 4, in an embodiment, the electronic device 200 may include a front window 201, a rear plate 202, a side bezel structure 203, a first support member 410, a second support member 420, a third support member 430, a display 301, a first substrate assembly 440, a second substrate assembly 450, a battery 460, or an antenna structure 470. In some embodiments, the electronic device 200 may omit at least one (e.g., the second support member 420 or the third support member 430) of the above components or may additionally include other components.

The first support member 410 may be, for example, positioned inside the electronic device 200 to be connected to the side bezel structure 203, or may be formed integrally with the side bezel structure 203. The first support member 410 may be made of, for example, a metallic material and/or a non-metallic material (e.g., polymer). In an embodiment, a conductive portion included in the first support member 410 may function as an electromagnetic shield for the display 301, the first substrate assembly 440, and/or the second substrate assembly 450. The first support member 410 and the side bezel structure 203 may be referred to as a front frame 400. The first support member 410 is a portion where components such as the display 301, the first substrate assembly 440, the second substrate assembly 450, or the battery 460 of a front frame 400 are disposed, and may contribute to durability or rigidity (e.g., torsional rigidity) of the electronic device 200. Hereinafter, the first support member 410 may be referred to as a support structure (e.g., bracket or mounting plate). In some embodiments, the front frame 400 may include sensor mounts 411a and 411b formed in an area corresponding to a position of the first camera module 307, the sensor module 306b, and the biometric sensor (e.g., a fingerprint sensor 306b) and having an opening facing the front surface (e.g., in the z direction) of the electronic device.

The display 301 may be positioned, for example, between the support structure 410 and the front window 201, and be disposed at one surface of the support structure 410. The first substrate assembly 440 and the second substrate assembly 450 may be positioned, for example, between the support structure 410 and the rear plate 202, and be disposed at the other surface of the support structure 410. The battery 460 may be positioned, for example, between the support structure 410 and the rear plate 202, and be disposed in the support structure 410.

According to an embodiment, the first substrate assembly 440 may include a first printed circuit board 441 (e.g., printed circuit board (PCB) or printed circuit board assembly (PBA)). The first substrate assembly 440 may include various electronic components electrically connected to the first PCB 441. The electronic components may be disposed on the first PCB 441 or electrically connected to the first PCB 441 through an electrical path, such as a cable or a flexible printed circuit board (FPCB). With reference to FIGS. 2 and 3, the electronic components may include, for example, a second microphone included in the second audio module 303, a second speaker included in the fourth audio module 305, the sensor module 306a, the first camera module 307, the plurality of second camera modules 308, the light emitting module 309, or the input module 310.

According to an embodiment, the second substrate assembly 450 may be disposed spaced apart from the first substrate assembly 440 with the battery 460 interposed therebetween when viewed from above the front window 201 (e.g., when viewed in the -z-axis direction). The second substrate assembly 450 may include a second PCB 442 electrically connected to the first PCB 441 of the first substrate assembly 440. The second substrate assembly 450 may include various electronic components electrically connected to the second PCB 442. The electronic components may be disposed on the second PCB 442 or electrically connected to the second PCB 442 through an electrical path, such as a cable or an FPCB. With reference to FIGS. 2 and 3, the electronic components may include, for example, a first microphone (or first microphone module) included in the first audio module 302, a first speaker included in the third audio module 304, a first connector included in the first connection terminal module 311, a second connector included in the second connection terminal module 312, and/or a fingerprint sensor 306b.

According to some embodiments, the first substrate assembly 440 or the second substrate assembly 450 may include a main PCB, a slave PCB disposed to partially overlap the main PCB, and/or an interposer substrate between the main PCB and the slave PCB.

The battery 460 is a device for supplying power to at least one component of the electronic device 200, and may include, for example, a non-rechargeable primary battery, a rechargeable secondary battery, or a fuel cell. The battery 460 may be integrally disposed inside the electronic device 200, or may be detachably disposed with the electronic device 200.

According to an embodiment, the second support member 420 may be interposed between the support structure 410 and the rear plate 202, and be coupled to the support structure 410 using a fastening element such as a bolt. At least a portion of the first substrate assembly 440 may be interposed between the support structure 410 and the second support member 420, and the second support member 420 may cover and protect the first substrate assembly 440. The third support member 430 may be positioned at least partially spaced apart from the second support member 420 with the battery 460 therebetween when viewed from above the rear plate 202 (e.g., when viewed in the +z-axis direction). The third support member 430 may be interposed between the support structure 410 and the rear plate 202, and be coupled to the support structure 410 using a fastening element such as a bolt. At least a portion of the second substrate assembly 450 may be interposed between the support structure 410 and the third support member 430, and the third support member 430 may cover and protect the second substrate assembly 450. The second support member 420 and/or the third support member 430 may be made of a metallic material and/or a non-metallic material (e.g., polymer). In some embodiments, the second support member 420 may serve as an electromagnetic shield for the first substrate assembly 440, and the third support member 430 may serve as an electromagnetic shield for the second substrate assembly 450. In some embodiments, the second support member 420 and/or the third support member 430 may be referred to as a rear case.

In some embodiments, an integral substrate assembly including a first substrate assembly 440 and a second substrate assembly 450 may be implemented. For example, when viewed from above the rear plate 202 (e.g., when viewed in the +z-axis direction), the substrate assembly may include a first portion and second portion positioned spaced apart from each other with the battery 460 therebetween, and a third portion extended between the battery 460 and the side bezel structure 203 and connecting the first portion and the second portion. In this case, an integral support member including a second support member 420 and a third support member 430 may be implemented.

According to an embodiment, the antenna structure 470 may be interposed between the second support member 420 and the rear plate 202. In some embodiments, the antenna structure 470 may be interposed between the battery 460 and the rear plate 202. The antenna structure 470 may be implemented in a film form, such as, for example, an FPCB. The antenna structure 470 may include at least one conductive pattern utilized as a loop-shaped radiator. For example, the at least one conductive pattern may include a flat spiral conductive pattern (e.g., flat coil or pattern coil). In an embodiment, the at least one conductive pattern included in the antenna structure 470 may be electrically connected to a wireless communication circuit (or wireless communication module) included in the first substrate assembly 440. For example, the at least one conductive pattern may be utilized for short-range wireless communication, such as near field communication (NFC). For another example, the at least one conductive pattern may be utilized for magnetic secure transmission (MST) to transmit and/or receive magnetic signals. In some embodiments, at least one conductive pattern included in the antenna structure 470 may be electrically connected to a power transmission and reception circuit included in the first substrate assembly 440. The power transmission and reception circuit may wirelessly receive power from an external electronic device or wirelessly transmit power to an external electronic device using the at least one conductive pattern. The power transmission and reception circuit may include a power management module, for example, a power management integrated circuit (PMIC) or a charger integrated circuit (charger IC). The power transmission and reception circuit may charge the battery 460 using power wirelessly received using the conductive pattern.

According to an embodiment, the electronic device 200 has a bar type or plate type appearance, but is not limited thereto. For example, the illustrated electronic device 200 may be part of a foldable electronic device, a slidable electronic device, a stretchable electronic device, and/or a rollable electronic device.

The electronic device 200 may further include various components according to a provision form thereof. These components are not all listed because they are modified in various ways according to the convergence trend of the electronic device 200, but components equivalent to the above-mentioned components may be additionally included in the electronic device 200. In various embodiments, specific components may be excluded from the above-mentioned components or replaced with other components according to a provision form of the electronic device 200.

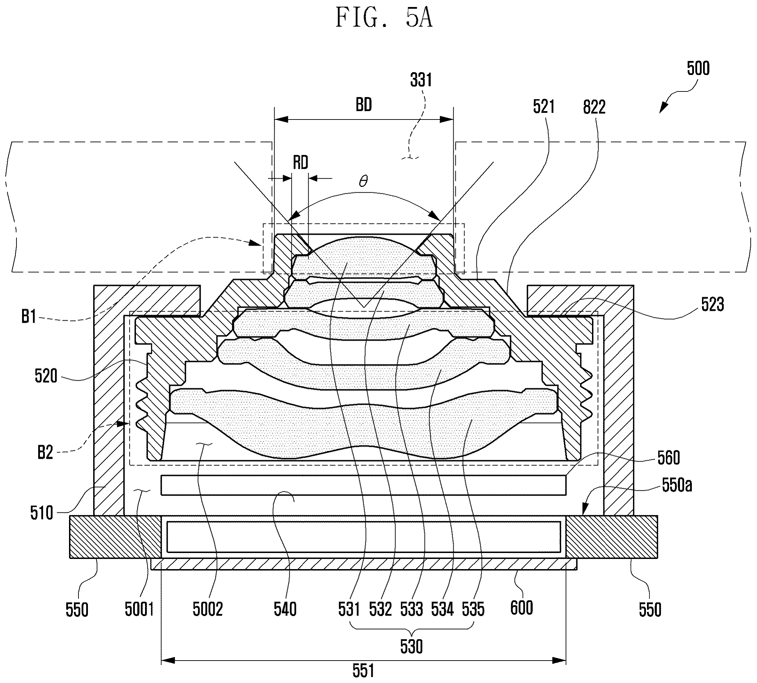

FIG. 5A is a cross-sectional view illustrating a camera module 500 according to various embodiments of the disclosure.

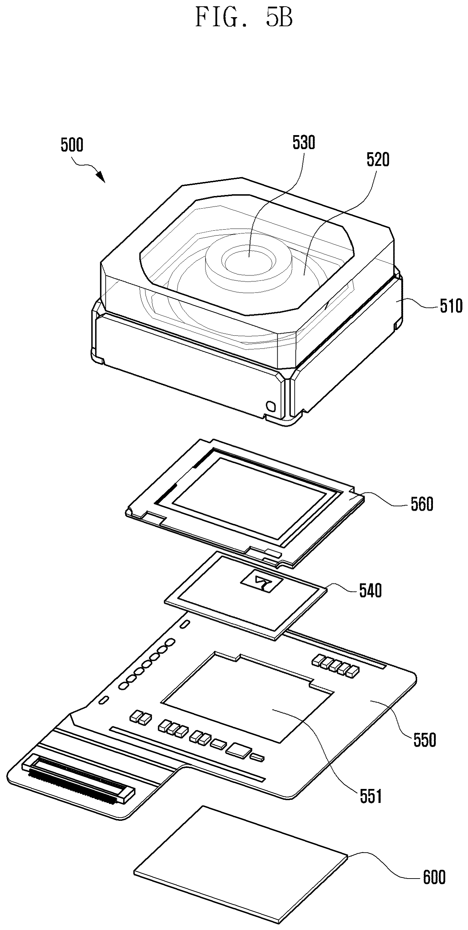

FIG. 5B is an exploded perspective view illustrating a camera module 500 according to various embodiments of the disclosure.

With reference to FIGS. 5A and 5B, the camera module 500 may include a camera housing 510, a barrel 520, an optical system 530 disposed in an internal space 5002 of the barrel 520, and at least one image sensor 540. The optical system 530 may be an optical structure that collects light entering at a constant viewing angle Θ to form an image. In various embodiments, the optical system 530 may include a plurality of lenses 531, 532, 533, 534, and 535, but it will be apparent to those skilled in the art that the optical system 530 of the disclosure is not limited to a refractive optical system such as lenses 531, 532, 533, 534, and 535, and may include one or more reflective optical systems.

In some embodiments, an overall diameter BD of an upper end portion B1 of the barrel 520 may be formed relatively smaller than that of a lower end portion B2 in order to reduce the size visible from the outside. For example, the barrel 520 may be formed to have a relatively small diameter by reducing a size RD of a lens non-effective area (e.g., flange) compared to a lens effective area in the case of the upper end portion B1. To this end, the barrel 520 may have at least one inclined portion 522 and stepped portions 521 and 523.

In various embodiments, a filter 560 may be interposed between the optical system 530 and the image sensor 540. The filter 560 may be a member that protects the image sensor 540 and that blocks wavelength bands (e.g., ultraviolet and/or infrared) of light passing through the optical system 530 except for wavelength bands detected by the image sensor 540.

In various embodiments, the camera module 500 may include a first substrate 550. The first substrate 550 may be a circuit board electrically connected to the image sensor 540 to process a read out signal of the image sensor 540 and/or transmit the read out signal of the image sensor 540 to a main substrate (e.g., the first substrate assembly 440 of FIG. 4) of the electronic device. In various embodiments, the first substrate 550 may include a sensor hole 551 formed on a first surface 550a to at least partially penetrate the first substrate 550. The image sensor 540 may be at least partially positioned inside the sensor hole 551. Accordingly, an increase in the size of the camera module 500 due to a thickness of the image sensor 540 may be at least partially offset. The image sensor 540 and the first substrate 550 may be electrically connected to each other by, for example, a method such as wire bonding.

In various embodiments, the camera module 500 may include a second substrate 600. The second substrate 600 may be disposed to at least partially overlap the sensor hole 551. For example, the second substrate 600 may be disposed to at least partially cover the sensor hole 551 at a surface opposite to the first surface 550a. The sensor hole 551 formed to reduce the thickness of the camera module 500 may become an inlet passage for electromagnetic interference (EMI) such as RF noise, and the second substrate 600 may block EMI. In various embodiments, the second substrate 600 may include a printed circuit board (PCB) and/or a flexible printed circuit board (FPCB) including a conductive pattern 610 for RF noise shielding. In some embodiments, the image sensor 540 may be bonded and disposed on the second substrate 600 by means such as a die attachment film.

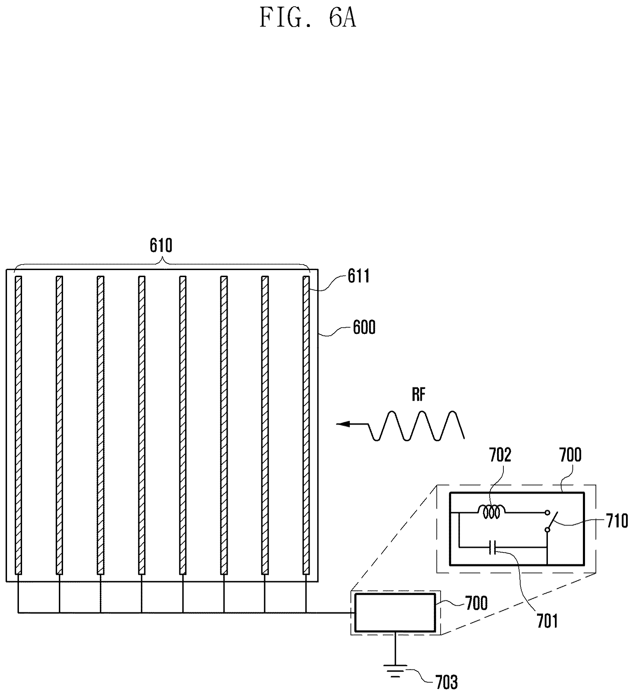

FIG. 6A is a plan view illustrating a second substrate 600 and a shielding control circuit 700 of a camera module 500 according to various embodiments.

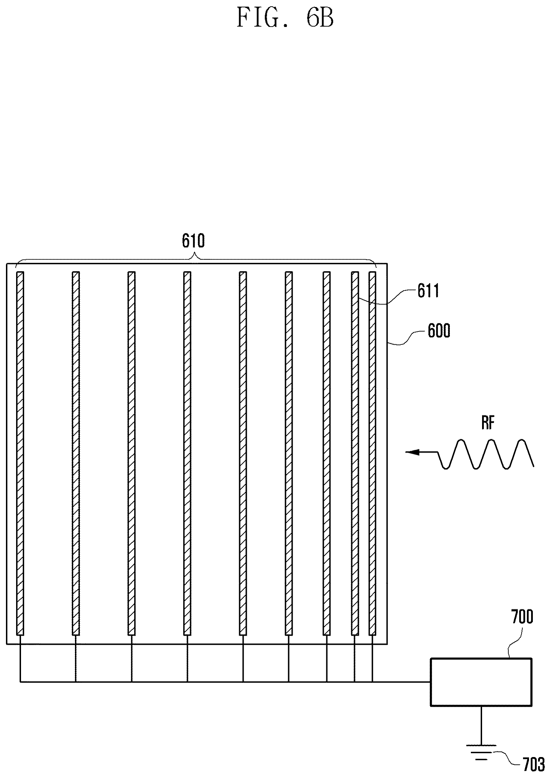

FIG. 6B is a plan view illustrating a second substrate 600 of a camera module 500 according to various embodiments.

With reference to FIG. 6A, the second substrate 600 may include a conductive pattern 610. The conductive pattern 610 may be a conductive material (e.g., copper and/or aluminum) formed on the second substrate 600 in order to impart a shielding effect, such as a Faraday cage. The conductive pattern 610 may include a metal foil patterned by a method such as etching, for example.

In various embodiments, the conductive pattern 610 may include a plurality of conductive strips 611. The conductive strips 611 may be patterns of conductive material extended in a certain direction to be disposed parallel to each other. In various embodiments, the conductive strips 611 may be arranged substantially perpendicular to a direction in which RF noise (RF) is introduced. In various embodiments, the conductive pattern 610 may be electrically connected to a ground electrode 703 in order to absorb energy of RF noise (RF) and release it.

In various embodiments, the electronic device may include a shielding control circuit 700 that grounds the conductive pattern 610 with the ground electrode 703. In various embodiments, the shielding control circuit 700 may be formed on the first substrate 550 and/or the second substrate 600. In other embodiments, the shielding control circuit 700 may be mounted on a main substrate (e.g., the first substrate assembly 440 of FIG. 4) of the electronic device.

In various embodiments, the shielding control circuit 700 may include a switch 710 for this purpose. The switch 710 may be a circuit element that opens and closes a circuit. The switch 710 may include a physical switch, such as a relay, as well as an electronic switch including at least one active element, such as a diode and/or a transistor.

In various embodiments, the shielding control circuit 700 may include additional circuit elements for impedance matching of the conductive pattern 610, such as an inductor 702 (e.g., coil, ferrite core, and/or chip inductor) and/or a capacitor 701 (e.g., a chip capacitor such as an MLCC, an electrolytic capacitor, and/or a ceramic capacitor).

The conductive pattern 610 may have parasitic capacitance and/or parasitic inductance together with the pattern itself and/or metallic components (e.g., the first support member 410 of FIG. 4) of the electronic device. The conductive pattern 610 may generate a shielding effect for other RF frequency bands, but the shielding effect may be reduced for an RF frequency band that matches a resonant frequency of the conductive pattern 610 determined by the parasitic capacitance and/or parasitic inductance. Therefore, the shielding control circuit 700 may include additional circuit elements to tune a resonant frequency of the conductive pattern 610, thereby minimizing the reduction in the shielding effect described above.

With reference to FIG. 6B, the conductive pattern 610 of the second substrate 600 according to various embodiments may have spacing of the conductive strips 611 that gradually change with respect to an introduction direction of RF noise. For example, the conductive strips 611 may be arranged at narrower spacings as they move in an introduction direction of RF noise. Through the disposition as described above, the conductive pattern 610 may be concentratedly disposed in a main introduction direction of RF noise, thereby effectively shielding the camera module 500.

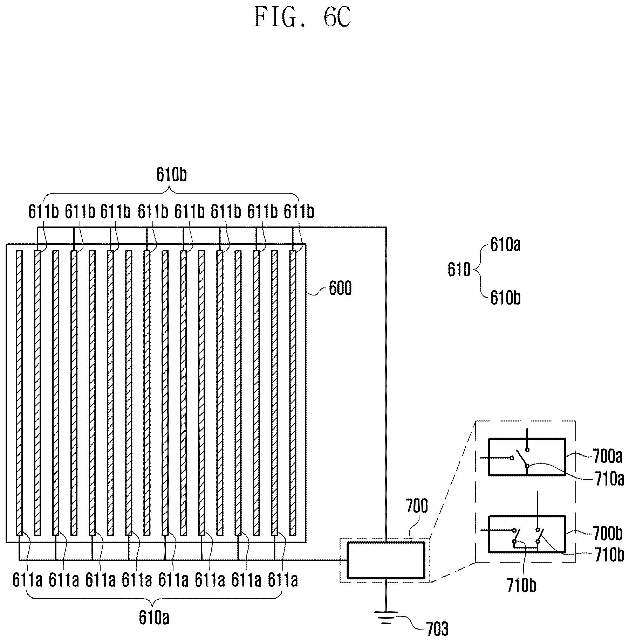

FIG. 6C is a plan view illustrating a second substrate 600 and a shielding control circuit 700 of a camera module 500 according to various embodiments.

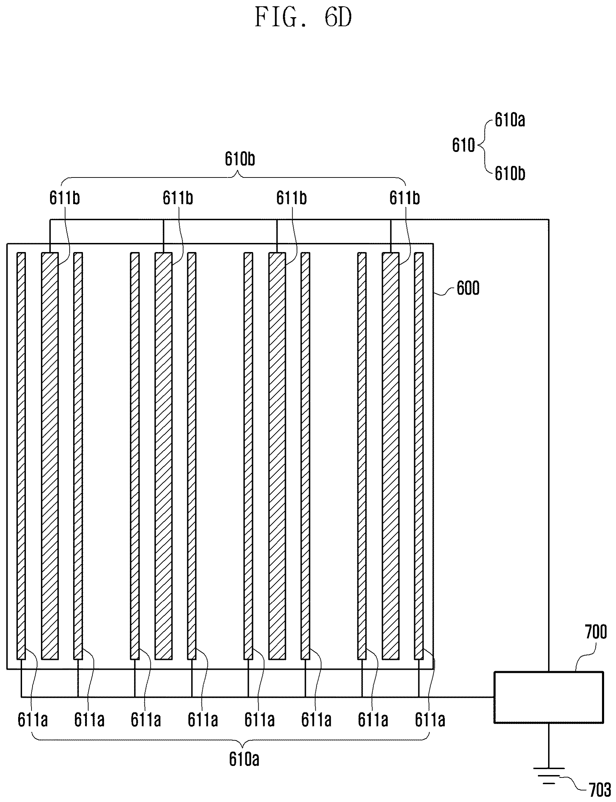

FIG. 6D is a plan view illustrating a second substrate 600 of a camera module 500 according to various embodiments.

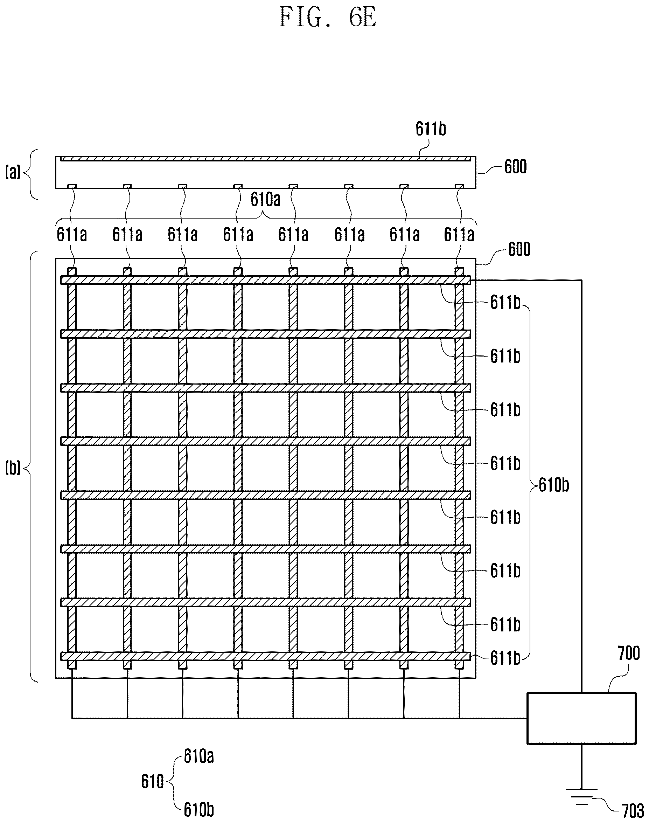

FIG. 6E is a plan view and side view illustrating a second substrate 600 of a camera module 500 according to various embodiments.

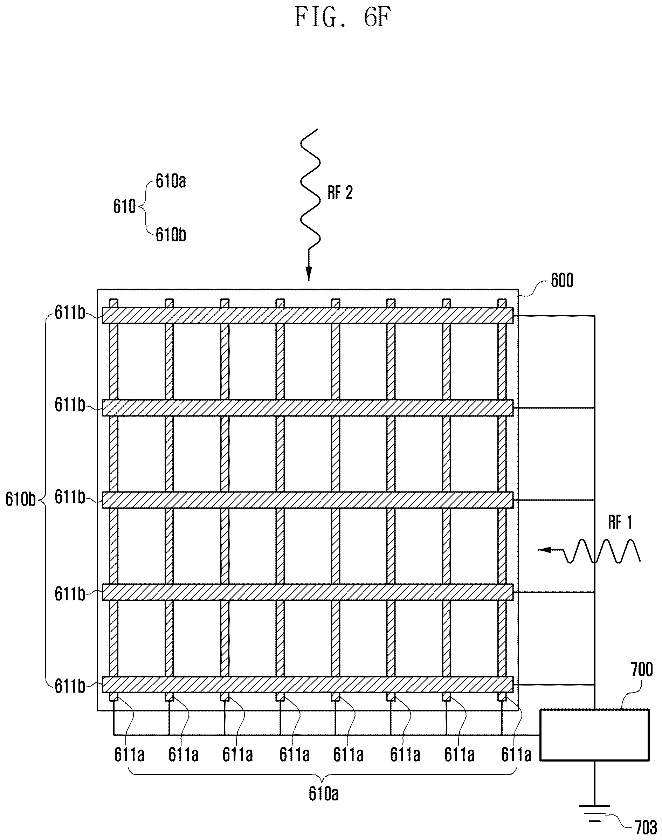

FIG. 6F is a plan view illustrating a second substrate 600 of a camera module 500 according to various embodiments.

With reference to FIGS. 6C to 6F, the second substrate 600 according to various embodiments may include a plurality of conductive patterns 610. For example, the conductive pattern 610 of the second substrate 600 may include a first conductive pattern 610a and a second conductive pattern 610b. In various embodiments, the first conductive pattern 610a and the second conductive pattern 610b may each include at least one conductive strip (e.g., the conductive strip 611 of FIG. 6A). For example, the first conductive pattern 610a may include a first conductive strip 611a, and the second conductive pattern 610b may include a second conductive strip 611b. Although FIGS. 6C to 6F illustrate only an embodiment including a first conductive pattern 610a and a second conductive pattern 610b, the disclosure is not limited thereto, and it will be apparent to those skilled in the art that the second substrate 600 may include three or more conductive patterns 610.

With reference to FIG. 6C, a shielding control circuit 700 according to various embodiments may selectively ground a first conductive pattern 610a and a second conductive pattern 610b with a ground electrode 703. In some embodiments, the first shielding control circuit 700a may include a single pole double throw (SPDT) switch 710a and selectively connect the first conductive pattern 610a and the second conductive pattern 610b with the ground electrode 703. In other embodiments, the second shielding control circuit 700b may include a plurality of single pole single throw (SPST) switches 710b and independently connect the first conductive pattern 610a and the second conductive pattern 610b with the ground electrode 703.

The first conductive pattern 610a and the second conductive pattern 610b may have different impedances (capacitance and/or inductance), and impedances of the first conductive pattern 610a and the second conductive pattern 610b may be different when both are grounded with the ground electrode 703 and when either one of them is grounded with the ground electrode 703. Accordingly, because the switch 710 of the shielding control circuit 700 is configured to selectively ground the first conductive pattern 610a and the second conductive pattern 610b, the shielding control circuit 700 may make a resonance frequency of the conductive pattern 610 different, thereby increasing or decreasing the shielding effect for different RF noise bands. Because switches (e.g., the first shielding control circuit 700a, the second shielding control circuit 700b) of the shielding control circuit 700 may be actively controlled during use, active control of the resonant frequency is possible by the above-described constitution.

With reference to FIG. 6D, the first conductive pattern 610a and the second conductive pattern 610b may have conductive strips 611a and 611b having different widths and/or spacings. For example, the first conductive strip 611a may be disposed at narrow intervals and have a narrow width, and the second conductive strip 611b may be disposed at wider intervals and have a wide width. It will be apparent to those skilled in the art that combinations of widths and spacings of the first conductive strip 611a and the second conductive strip 611b are not limited to the above-described combinations as illustrated in FIG. 6D.

The width and/or spacing of the conductive strips 611 may affect parasitic inductance and/or parasitic capacitance of the conductive pattern 610. Therefore, the first conductive pattern 610a and the second conductive pattern 610b configured to have different widths and/or spacings of the conductive strips 611 may have different resonant frequencies, thereby having high shielding effects for different frequency bands. For example, the first conductive pattern 610a including the first conductive strip 611a having a relatively narrow width may have a high shielding effect for the first frequency band, and the second conductive pattern 610b including the second conductive strip 611b having a relatively wide width may have a high shielding effect for the second frequency band. Further, the first conductive pattern 610a in which the first conductive strips 611a are disposed at relatively close intervals may have a high shielding effect for the first frequency band, and the second conductive pattern 610b in which the second conductive strips 611b are disposed at relatively close intervals may have a high shielding effect for the second frequency band.

In various embodiments, the shielding control circuit 700 may ground different conductive patterns (e.g., the first conductive pattern 610a, the second conductive pattern 610b) with the ground electrode 703 when the electronic device communicates in different frequency bands. For example, the shielding control circuit 700 may ground the first conductive pattern 610a configured to have a high shielding effect for the first frequency band when the electronic device communicates in a first frequency band, and ground the second conductive pattern 610b configured to have a high shielding effect for the second frequency band when the electronic device communicates in the second frequency band. To this end, the shielding control circuit 700 may be connected to, for example, a communication module (e.g., the communication module 190 of FIG. 1) of the electronic device to be configured to operate the switch 710 according to whether communication is performed in the first frequency band or the second frequency band. Accordingly, a shielding performance of the second substrate 600 may be actively adjusted according to a use frequency band of the electronic device. Although FIGS. 6C to 6F illustrate only an embodiment including a first conductive strip 611a and a second conductive strip 611b, the disclosure is not limited thereto, and it will be apparent to those skilled in the art that the second substrate 600 may include three or more conductive strips 611 having different widths and/or spacings.

With reference to FIG. 6E, the second substrate 600 may include a plurality of conductive patterns 610 oriented in different directions. For example, the conductive patterns 610 of the second substrate 600 may include a first conductive pattern 610a oriented in a first direction and a second conductive pattern 610b oriented in a second direction. The first conductive pattern 610a and the second conductive pattern 610b may be disposed to form a plurality of layers within, for example, the second substrate 600 so as to avoid being shortcircuited with each other.

The second substrate 600 may actively respond to RF noise entering from different directions by including conductive patterns 610 oriented in different directions. For example, the electronic device may include a plurality of antennas (e.g., the antenna module 197 of FIG. 1, the antenna structure 470 of FIG. 4) disposed at different positions based on the camera module 500. For example, the control module (e.g., the shielding control circuit 700) may be configured to ground the first conductive pattern 610a oriented substantially perpendicular to the first direction with the ground electrode 703 when the antenna positioned in the first direction radiates electromagnetic waves, and to ground the second conductive pattern 610b oriented substantially perpendicular to the second direction with the ground electrode 703 when the antenna positioned in the second direction radiates electromagnetic waves.

Although FIG. 6E illustrates only an embodiment in which the first conductive pattern 610a and the second conductive pattern 610b are laminated in two layers, the disclosure is not limited thereto and it will be apparent to those skilled in the art that the second substrate 600 may have three or more layers and include three or more conductive patterns 610 oriented in different directions.

With reference to FIG. 6F, the plurality of conductive patterns 610 may include conductive strips 611a and 611b disposed in different directions and having different widths and/or spacings. For example, the conductive pattern 610 of the second substrate 600 may include a first conductive pattern 610a including a first conductive strip 611a oriented in a first direction, and a second conductive pattern 610b including a second conductive strip 611b oriented in a second direction and having a spacing and/or width different from that of the first conductive strip 611a. The above-described constitution may actively respond to and shield a plurality of antennas disposed at different positions of the electronic device when they each radiate electromagnetic waves at different frequencies RF1 and RF2. For example, when one of the plurality of antennas radiates electromagnetic waves of a first frequency band RF1 in a first direction, the shielding control circuit 700 may ground the first conductive pattern 610a oriented to shield electromagnetic waves incident in the first direction by connecting it to the ground electrode 703. Further, when another of the plurality of antennas radiates electromagnetic waves of a second frequency band RF1 in a second direction, the shielding control circuit 700 may ground the second conductive pattern 610b oriented to shield electromagnetic waves incident in the second direction by connecting it to the ground electrode 703. The shielding control circuit 700 may actively control a shielding capability of the conductive patterns 610a and 610b according to changes in the radio wave radiation environment, as described above.

FIG. 6F illustrates only an embodiment in which the first conductive pattern 610a and the second conductive pattern 610b are laminated and disposed in two layers, but the disclosure is not limited thereto, and it will be apparent to those skilled in the art that the second substrate 600 may have three or more layers and include three or more conductive patterns 610 having different orientations, widths, and/or spacings of the conductive strips.

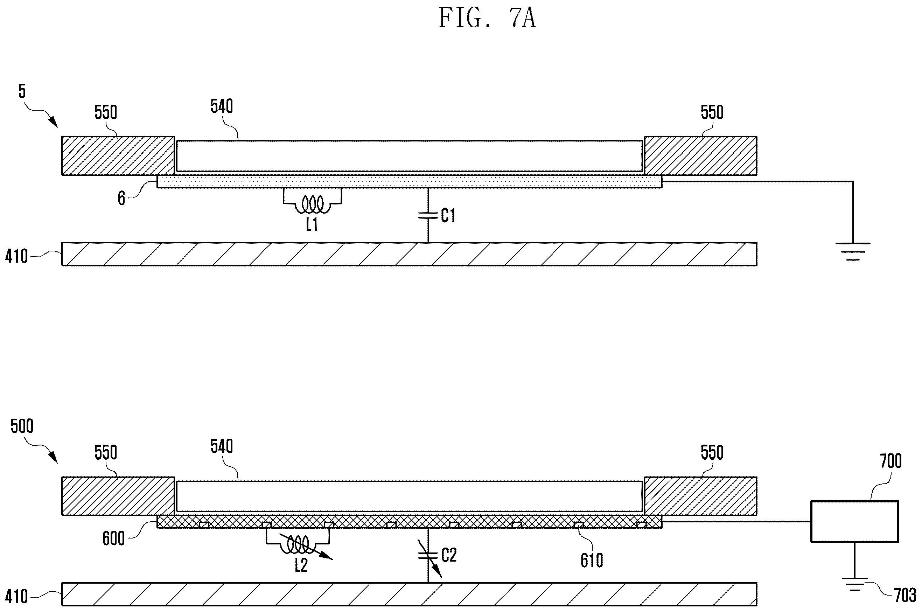

FIG. 7A is a schematic diagram illustrating a camera module 500 according to a comparative example and an embodiment of the disclosure.

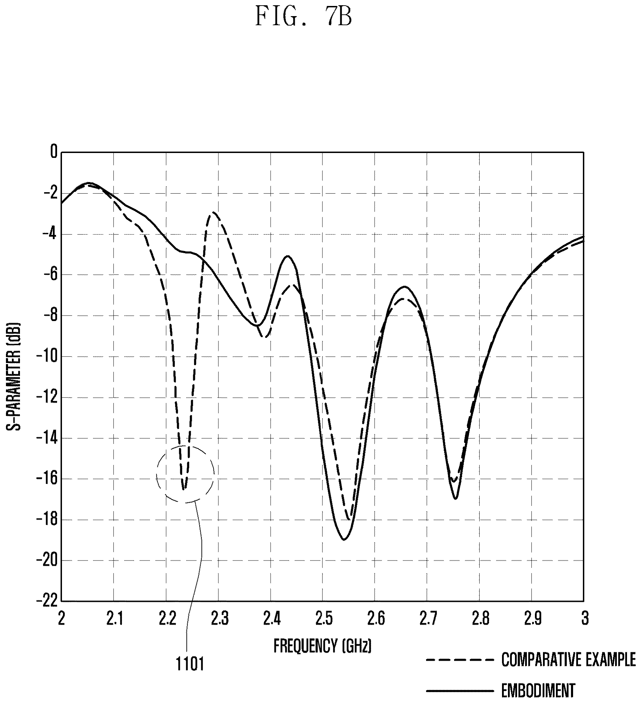

FIG. 7B is a graph illustrating a shielding performance for a frequency band of a camera module 500 according to a comparative example and an embodiment of the disclosure.

In FIG. 7A, for clarity, components of the camera module 500 other than a first substrate 550, an image sensor 540, a second substrate 600, and a shielding control circuit 700 are not illustrated.

Comparative example 5 of FIG. 7A is a camera module 5 including a passive conductive shielding member 6 that does not include a conductive pattern 610 and a shielding control circuit 700 of the disclosure. Circuit elements such as capacitors C1 and C2 and inductors L1 and L2 illustrated in FIG. 7A are used for illustrating parasitic capacitance and parasitic inductance caused by the disposition of each member, and it will be apparent to those skilled in the art that this does not mean that actual physical circuit elements are disposed as illustrated.

FIG. 7B is a graph illustrating measured S-parameters of an electronic device including a camera module 500 according to a comparative example and an embodiment of the disclosure. A low dB value indicates a low blocking rate of RF noise.

With reference to FIG. 7A, a shielding member 6 according to the comparative example may have static parasitic inductance L1 and parasitic capacitance C1 by itself and/or in combination with a metallic component (e.g., the first support member 410 of FIG. 4) of the electronic device, and a resonant frequency due to the parasitic inductance L1 and parasitic capacitance C1 may not be tuned to prevent resonance with a frequency band in which the electronic device communicates. Accordingly, a shielding member of the comparative example may have a shielding performance for some frequency bands, but RF noise may be introduced into the image sensor and the camera module 500 due to the resonance phenomenon for other frequency bands.

In contrast, the second substrate 600 according to the embodiment of the disclosure includes a conductive pattern 610, and parasitic inductance L2 and parasitic capacitance C2 may be varied by adjusting the shielding control circuit 700. Accordingly, because the resonant frequency may be actively adjusted in response to the frequency band and inflow direction of RF noise introduced into the camera module 500, the camera module 500 may be protected from RF noise in a wide frequency band and various radiation environments compared to the comparative example.

With reference to FIG. 7B, the shielding member according to the comparative example has a phenomenon in which a blocking rate of RF noise is lowered due to a resonance phenomenon 1101 in 2.2 to 2.3 gigahertz (GHz) band, but in the embodiment of the disclosure, it may be seen that a phenomenon in which a blocking rate of RF noise is lowered due to the resonance phenomenon is not caused or is reduced by changing the resonance frequency corresponding to the corresponding frequency band. Therefore, the second substrate 600 including the conductive pattern 610 according to the disclosure may protect the camera module 500 from RF noise in various frequency bands and radiation environments.

According to various embodiments of the disclosure, an electronic device may include a camera module 500 and be configured to communicate in at least one RF frequency band, wherein the camera module 500 may include a first substrate 550 including a sensor hole 551 formed on a first surface of the first substrate 550 so as to at least partially penetrate the first substrate 550, an image sensor positioned at least partially within the sensor hole 551 and electrically connected to the first substrate 550, and a second substrate 600 disposed to partially overlap the sensor hole 551 at a surface opposite to the first surface of the first substrate 550 and including at least one conductive pattern 610.

In various embodiments, the conductive pattern 610 may include a plurality of conductive strips 611.

In various embodiments, a width and spacing of the plurality of conductive strips 611 may be configured to have parasitic capacitance and parasitic inductance that block an RF frequency band of the electronic device.

In various embodiments, the spacing of the plurality of conductive strips 611 may be gradually changed based on a direction in which a signal of the RF frequency band is introduced.

In various embodiments, the conductive pattern 610 may include a first conductive pattern 610a including a first conductive strip 611a and a second conductive pattern 610b including a second conductive strip 611b, and the first conductive strip 611a and the second conductive strip 611b may differ from each other in at least one of a width, an spacing, or an arrangement direction of the conductive strips 611.

In various embodiments, the camera module 500 may include a shielding control circuit 700 electrically connected to the conductive pattern 610, and the shielding control circuit 700 may be configured to selectively ground the conductive pattern 610.

In various embodiments, the shielding control circuit 700 may include a circuit element electrically connected to the conductive pattern 610, and impedance of the circuit element may be configured such that a composite impedance value of the conductive pattern 610 and the shielding control circuit 700 is adjusted to a value capable of blocking the RF frequency band.

In various embodiments, the conductive pattern 610 may include a first conductive pattern 610a and a second conductive pattern 610b, and the shielding control circuit 700 may be constituted to selectively ground at least one of the first conductive pattern 610a or the second conductive pattern 610b.

In various embodiments, the electronic device may be constituted to communicate in a first RF frequency band RF1 and a second RF frequency band RF2, and the first conductive pattern 610a may be constituted to have an impedance value that blocks the first RF frequency band RF1, and the second conductive pattern 610b may be constituted to have an impedance value that blocks the second RF frequency band RF2.

In various embodiments, the shielding control circuit 700 may be constituted to ground the first conductive pattern 610a when the electronic device communicates in the first RF frequency band RF1, and to ground the second conductive pattern 610b when the electronic device communicates in the second RF frequency band RF2.

According to various embodiments of the disclosure, a camera module 500 included in an electronic device constituted to communicate in at least one RF frequency band may include a first substrate 550 including a sensor hole 551 formed on a first surface of the first substrate 550 so as to at least partially penetrate the first substrate 550, an image sensor positioned at least partially within the sensor hole 551 and electrically connected to the first substrate 550, and a second substrate 600 disposed to partially overlap the sensor hole 551 at a surface opposite to the first surface of the first substrate 550 and including at least one conductive pattern 610.

In various embodiments, the conductive pattern 610 may include a plurality of conductive strips 611.

In various embodiments, the width and spacing of the plurality of conductive strips 611 may be confogured to have parasitic capacitance and parasitic inductance that block the RF frequency band of the electronic device.

In various embodiments, the spacing of the plurality of conductive strips 611 may be gradually changed based on a direction in which a signal of the RF frequency band is introduced.

In various embodiments, the conductive pattern 610 may include a first conductive pattern 610a including a first conductive strip 611a and a second conductive pattern 610b including a second conductive strip 611b, and the first conductive strip 611a and the second conductive strip 611b may differ from each other in at least one of a width, an spacing, or an arrangement direction of the conductive strips 611.

In various embodiments, the camera module 500 may include a shielding control circuit 700 electrically connected to the conductive pattern 610, and the shielding control circuit 700 may be constituted to selectively ground the conductive pattern 610.

In various embodiments, the shielding control circuit 700 may include a circuit element electrically connected to the conductive pattern 610, and impedance of the circuit element may be configured such that a composite impedance value of the conductive pattern 610 and the shielding control circuit 700 is adjusted to a value capable of blocking the RF frequency band.

In various embodiments, the conductive pattern 610 may include a first conductive pattern 610a and a second conductive pattern 610b, and the shielding control circuit 700 may be constituted to selectively ground at least one of the first conductive pattern 610a or the second conductive pattern 610b.

In various embodiments, the electronic device may be constituted to communicate in a first RF frequency band RF1 and a second RF frequency band RF2, the first conductive pattern 610a may be configured to have an impedance value that blocks the first RF frequency band RF1, and the second conductive pattern 610b may be configured to have an impedance value that blocks the second RF frequency band RF2.

In various embodiments, the shielding control circuit 700 may be constituted to ground the first conductive pattern 610a when the electronic device communicates in the first RF frequency band RF1, and to ground the second conductive pattern 610b when the electronic device communicates in the second RF frequency band RF2.

Embodiments disclosed in this document disclosed in this specification and drawings merely present specific examples to easily describe the technical content according to the embodiments disclosed in this document and to help the understanding of the embodiments disclosed in this document, and they do not intend to limit the scope of the embodiments disclosed in this document. Accordingly, in addition to the embodiments disclosed herein, all changes or modifications derived from the technical ideas of various embodiments disclosed in this document should be interpreted as being included in the scope of various embodiments disclosed in this document.

## Claims

1. An electronic device including a camera module and configured to communicate in at least one radio frequency (RF) frequency band, wherein the camera module comprises:
a first substrate including a sensor hole formed on a first surface of the first substrate so as to at least partially penetrate the first substrate;
an image sensor positioned at least partially within the sensor hole and electrically connected to the first substrate; and
a second substrate disposed to partially overlap the sensor hole at a surface opposite to the first surface of the first substrate and including at least one conductive pattern.

2. The electronic device of claim 1, wherein the conductive pattern comprises a plurality of conductive strips.

3. The electronic device of claim 1, wherein a width and spacing of the plurality of conductive strips are configured to have parasitic capacitance and parasitic inductance that block the RF frequency band of the electronic device.

4. The electronic device of claim 3, wherein the spacing of the plurality of conductive strips is gradually changed based on a direction in which a signal of the RF frequency band is introduced.

5. The electronic device of claim 1, wherein the conductive pattern comprises a first conductive pattern including a first conductive strip and a second conductive pattern including a second conductive strip, and
the first conductive strip and the second conductive strip differ from each other in at least one of a width, spacing, or arrangement direction of the conductive strips.

6. The electronic device of claim 1, further comprising a shielding control circuit electrically connected to the conductive pattern,
wherein the shielding control circuit is constituted to selectively ground the conductor pattern.

7. The electronic device of claim 6, wherein the shielding control circuit comprises a circuit element electrically connected to the conductor pattern, and
impedance of the circuit element is configured such that a composite impedance value of the conductor pattern and the shielding control circuit is adjusted to a value capable of blocking the RF frequency band.

8. The electronic device of claim 7, wherein the conductor pattern comprises a first conductor pattern and a second conductor pattern,
the shielding control circuit is constituted to selectively ground at least one of the first conductor pattern or the second conductor pattern,
the electronic device is constituted to communicate in a first RF frequency band and a second RF frequency band,
the first conductor pattern is constituted to have an impedance value that blocks the first RF frequency band,
the second conductor pattern is constituted to have an impedance value that blocks the second RF frequency band, and
the shielding control circuit is constituted to ground the first conductor pattern when the electronic device communicates in the first RF frequency band, and to ground the second conductor pattern when the electronic device communicates in the second RF frequency band.

9. A camera module included in an electronic device constituted to communicate in at least one RF frequency band, the camera module comprising:
a first substrate including a sensor hole formed on a first surface of the first substrate so as to at least partially penetrate the first substrate;
an image sensor positioned at least partially within the sensor hole and electrically connected to the first substrate; and
a second substrate disposed to partially overlap the sensor hole at a surface opposite to the first surface of the first substrate and including at least one conductive pattern.

10. The camera module of claim 9, wherein the conductive pattern comprises a plurality of conductive strips.

11. The camera module of claim 9, wherein a width and spacing of the plurality of conductive strips are configured to have parasitic capacitance and parasitic inductance that block the RF frequency band of the electronic device, and
the spacing of the plurality of conductive strips is gradually changed based on a direction in which a signal of the RF frequency band is introduced.

12. The camera module of claim 9, wherein the conductive pattern comprises a first conductive pattern including a first conductive strip and a second conductive pattern including a second conductive strip, and
the first conductive strip and the second conductive strip differ from each other in at least one of a width, spacing, or arrangement direction of the conductive strips.

13. The camera module of claim 9, further comprising a shielding control circuit electrically connected to the conductive pattern,
wherein the shielding control circuit is constituted to selectively ground the conductor pattern.

14. The camera module of claim 13, wherein the shielding control circuit comprises a circuit element electrically connected to the conductor pattern, and
impedance of the circuit element is configured such that a composite impedance value of the conductor pattern and the shielding control circuit is adjusted to a value capable of blocking the RF frequency band.

15. The camera module of claim 14, wherein the conductor pattern comprises a first conductor pattern and a second conductor pattern,
the shielding control circuit is constituted to selectively ground at least one of the first conductor pattern or the second conductor pattern,
the electronic device is constituted to communicate in a first RF frequency band and a second RF frequency band,
the first conductor pattern is constituted to have an impedance value that blocks the first RF frequency band, and
the second conductor pattern is constituted to have an impedance value that blocks the second RF frequency band, and
the shielding control circuit is constituted to ground the first conductor pattern when the electronic device communicates in the first RF frequency band, and to ground the second conductor pattern when the electronic device communicates in the second RF frequency band.
